# EUROPÄISCHE PATENTSCHRIFT

(11) **EP 2 266 380 B1**
(45) Veröffentlichungstag und Bekanntmachung des Hinweises auf die Patenterteilung: **21.09.2011**
(21) Anmeldenummer: 09731205.2
(22) Anmeldetag: 11.03.2009
(51) Int. Cl.: H05K 13/04, H05K 13/08

(54) **OPTISCHE ERFASSUNGSVORRICHTUNG UND VERFAHREN FÜR DIE ERFASSUNG VON OBERFLÄCHEN VON BAUTEILEN**
OPTICAL DETECTION DEVICE AND METHOD FOR DETECTING SURFACES OF COMPONENTS
SYSTÈME DE DÉTECTION OPTIQUE ET PROCÉDÉ POUR DÉTECTER DES SURFACES DE COMPOSANTS

(30) Priorität: 12.04.2008 DE 102008018586
(43) Veröffentlichungstag der Anmeldung: 29.12.2010
(73) Patentinhaber: Mühlbauer AG, 93426 Roding (DE)
(72) Erfinder: PRAKAPENKA, Uladimir, 93426 Roding (DE); BRANDL, Franz, 93455 Traitsching (DE)
(74) Vertreter: Schmidt, Steffen
(86) Internationale Anmeldenummer: PCT/EP2009/052823
(87) Internationale Veröffentlichungsnummer: WO 2009/124817

(56) Entgegenhaltungen:
- US-A1- 2006 023 936
- US-B1- 6 285 782

## Beschreibung

Die Erfindung betrifft eine optische Erfassungsvorrichtung und ein Verfahren für die Erfassung von mindestens einer Oberfläche mindestens eines Bauteils, wobei das Bauteil mittels eines Festhalteelementes unabhängig der vorausgehenden Prozessschritte von einer ersten zu einer zweiten Arbeitsstation transportierbar ist und eine Kameraeinrichtung auf die Oberflächen des Bauteiles gerichtet ist, gemäß den Oberbegriffen der Patentansprüche 1 und 10.

Herkömmlicherweise werden in sogenannten Pick- und Place-Vorrichtungen Bauteile, insbesondere elektronische Bauteile, wie beispielsweise ein Chip bzw. ein Die, von einem Festhalteelement, wie beispielsweise einem Greifelement, in einer ersten Arbeitsstation aufgenommen und
anschließend in einer zweiten Arbeitsstation auf oder in einem Trägermaterial abgelegt. Vor dem Ablegen des Bauteils findet üblicherweise eine Inspektion des Bauteiles derart statt, dass eine Oberfläche des Bauteils von einer Kameraeinrichtung bildlich aufgenommen wird, um hierdurch ein Oberflächenbild zu Überprüfungszwecken zu erzeugen.

Derartige Greifelemente halten an ihrer Unterseite das Bauteil während des Transportes und während der durchzuführenden Inspektion bzw. Erfassung der unteren Oberfläche des Bauteiles fest. Hierdurch kann zwar die unterhalb des Bauteils beabstandet angeordnete Kameraeinrichtung eine Bildaufnahme von der unterseitigen Oberfläche des Bauteiles durchführen, jedoch werden die seitlich angeordneten Oberflächen eines beispielsweise rechteckförmig oder quadratisch in seiner Grundfläche ausgebildeten Bauteiles nicht von der Kameraeinrichtung erfasst. Es ist ebenso bekannt, dass mittels aufwendig konstruierter Inspektionseinrichtungen zwar zusätzlich die Seitenflächen des mit einer rechteckigen Grundfläche ausgestatteten und quaderförmig ausgebildeten Bauteils bildlich erfasst werden können, allerdings ist hierfür zum einen ein Zwischenstopp während des Transportweges zum Aufnehmen der verschiedenen Oberflächen des Bauteiles und zum anderen entweder eine Mehrzahl an Kameraeinrichtungen oder ein aufwendig konstruiertes Spiegelsystem notwendig. Hieraus ergibt sich nachteilhaft ein geringerer Durchsatz derartiger Pickand Place-Vorrichtungen aufgrund des Zwischenstopps und der Herstellung aufwendiger Inspektionseinrichtungen.

US 6,285 782 B1 offenbart ein Verfahren zum Erkennen von elektronischen Bauteilen. Eine Erkennungseinheit weist einen Beleuchtungsbereich mit zwei ersten und zwei zweiten, schräg angeordneten Beleuchtungsquellen auf, die einander gegenüber angeordnet sind. Die zweiten Beleuchtungsquellen sind unterhalb der ersten Beleuchtungsquellen und mit einem geringeren Abstand zueinander als die ersten Beleuchtungsquellen angeordnet. Die ersten und zweiten Beleuchtungsquellen strahlen Licht verschiedener Wellenlängen ab. Befindet sich das elektronische Bauteil über der Erkennungseinheit und der Kamera, werden die zweiten Beleuchtungsquellen aktiviert und das elektronische Bauteil wird von den zweiten Beleuchtungsquellen beleuchtet. Die Anschlüsse des Bauteils, welche eine stark reflektierende Oberfläche aufweisen, reflektieren das Licht, so dass ein Bild von der Kamera aufgenommen wird, welches dazu verwendet werden kann, das Bauteil auszurichten. Anschließend können die ersten Beleuchtungsquellen aktiviert werden, welche so dann das elektronische Bauteil beleuchten, wobei die Beleuchtung des elektronischen Bauteils von oben erfolgt, so dass nur die Umrisse des elektronischen Bauteils von der Kamera aufgenommen werden können. Die Beleuchtung des elektronischen Bauteils von oben erfolgt über zwei Reflektoren, die je nach Winkel und Wellenlänge der eintreffenden Lichtstrahlen, die Lichtstrahlen absorbieren oder reflektieren.

US 2006/023936 A1 offenbart ein Verfahren und eine Vorrichtung zum Erkennen und Kontrollieren organischer Filme auf einer Leiterplatte. Die Vorrichtung von US 2006/023936 A1 weist eine Kamera, eine Strahlungsquelle, einen halbdurchlässigen Spiegel und einen Farbfilter auf. Die Strahlungsquelle ist im rechten Winkel, unterhalb und seitlich versetzt zu der Kamera angeordnet. Von der Strahlungsquelle wird Licht durch einen Farbfilter - so dass nur monochromes Licht den Farbfilter passiert - auf den halbdurchlässigen Spiegel gestrahlt. Der halbdurchlässige Spiegel, der schräg, in einem 45° Winkel zu der Kamera und auch zu dem Farbfilter angeordnet ist, lenkt das Licht auf eine unter der Kamera und dem halbdurchlässigen Spiegel angeordnete Leiterplatte. Die auf die Leiterplatte aufgebrachten Anschlüsse und Leiterstrukturen reflektieren das monochrome Licht und über den halbdurchlässigen Spiegel gelangt das reflektierte Licht zu der Kamera. Die Kamera macht von der so beleuchteten Leiterplatte eine Aufnahme und diese wird mit vorher gespeicherten Referenzwerten verglichen, um Aussagen über die Anschlüsse und organischen Filme der Leiterplatte aufgrund des reflektierten Licht zu treffen.

Deshalb ist es Aufgabe der Erfindung, ein optisches Erfassungssystem für die Erfassung von Oberflächen mindestens eines Bauteiles innerhalb einer Pick- und Place-Vorrichtung zur Verfügung zu stellen, welches eine schnelle optische Erfassung einer Mehrzahl unterschiedlich ausgerichteter Oberflächen des Bauteiles ermöglicht, einfach im Aufbau ist und kostengünstig herstellbar ist.

Diese Aufgabe wird vorrichtungsseitig gemäß den Merkmalen des Patentanspruches 1 und verfahrensseitig gemäß den Merkmalen des Patentanspruches 10 gelöst.

Ein wesentlicher Punkt der Erfindung liegt darin, dass bei einer optischen Erfassungsvorrichtung für die Erfassung von mindestens einer Oberfläche mindestens eines Bauteiles, insbesondere eines elektronischen Bauteils, welches mittels eines Festhalteelementes von einer ersten zu einer zweiten Arbeitsstation transportierbar ist, wobei eine Kameraeinrichtung auf eine erste Oberfläche des Bauteiles gerichtet ist, mindestens eine erste Lichtquelle, die erste Lichtstrahlen im kurzwelligen Bereich zur ersten Oberfläche sendet, mindestens eine zweite Lichtquelle, die zweite Lichtstrahlen im langwelligen Bereich zu mindestens einer zweiten Oberfläche des Bauteils sendet und die Kameraeinrichtung zum Empfang der an den Oberflächen reflektierten ersten und zweiten Lichtstrahlen verwendet werden. Hierbei ist die mindestens eine zweite Oberfläche gegenüber der mindestens einen ersten Oberfläche verschieden ausgerichtet, wie es beispielsweise bei quaderförmig ausgebildeten Bauteilen mit einer Unterseite und insgesamt vier seitlichen Oberflächen der Fall ist. Selbstverständlich kann es sich bei den zweiten Oberflächen auch um eine andere Anzahl an Oberflächen als vier handeln, sofern eine andere Form an Bauteilen vorliegt.

Durch die Verwendung von zwei Lichtquellen und den Lichtstrahlen, die unterschiedliche Wellenlängen ausstrahlen, wird es vorteilhaft ermöglicht, dass sowohl die unterseitige Oberfläche des Bauteiles, welches ein Die sein kann, als auch die seitlich umlaufenden angeordneten weiteren Oberflächen z.B. (Stirnseiten des Bauteiles) von einer gemeinsamen Kameraeinrichtung bildlich aufgenommen werden können, da ein derartiges Lichtquellen- bzw. Beleuchtungssystem das Aufeinanderabstimmen verschiedener Fokusebenen von der ersten Oberfläche einerseits und der mindestens einen zweiten Oberfläche andererseits auf einfache Weise zulässt. Würde stattdessen eine gemeinsame Lichtquelle mit einer gemeinsamen Wellenlänge der ausgestrahlten Lichtstrahlen zum Beleuchten sämtlicher Oberflächen des Bauteils verwendet werden, würden hierdurch unterschiedliche Fokusebenen im Bereich der Kameraeinrichtung entstehen, die eine scharfe Bildaufnahme sämtlicher Oberflächen auf einem beispielsweise flächenhaft ausgebildeten Sensorelement im Bereich der Kameraeinrichtung erschweren. Durch die Verwendung einer Lichtquelle hingegen, die im kurzwelligem Bereich arbeitet und für die Beleuchtung der unterseitig angeordneten Oberfläche des Bauteils zuständig ist, kann die sich hieraus ergebene Fokusebene zum scharfen Abbilden dieser ersten Oberfläche einfacher auf eine der Fokusebenen der zweiten Lichtstrahlen der mindestens einen zweiten Lichtquelle, die im langweiligen Bereich arbeitet, abgestimmt werden. Denn innerhalb eines Streckenabschnittes im Bereich der Kameraeinrichtung liegt eine Mehrzahl von Fokusebenen der reflektierten ersten Lichtstrahlen, wohingegen in diesem Streckenabschnitt nur wenige Fokusebenen der im langwelligen Bereich liegenden zweiten Lichtstrahlen vorhanden sind.

Zudem ergibt sich durch die vorliegende Erfindung vorteilhaft, dass lediglich eine und nicht mehrere Kameraeinrichtungen angeordnet werden müssen.

Ein weiterer wesentlicher Vorteil der Erfindung liegt darin, dass kein Zwischenstopp während des Transportes des Bauteils von einer ersten zu einer zweiten Arbeitsstation erforderlich ist, um das Bauteil - wie bisher üblich - in einem hierfür vorgesehenen Erfassungs- bzw. Inspektionsbereich vorzugsweise in Auf- und Abwärtsrichtung hineinzufahren, wenn man sowohl die unterseitige Oberfläche des Bauelementes als auch die umlaufenden seitlichen Oberflächen des beispielsweise quaderförmig ausgebildeten Bauelementes bildlich erfassen möchte.

Gemäß einer bevorzugten Ausführungsform ist mindestens eine zumindest teilweise reflektierende Strahlteilerplatte angeordnet, an der die Lichtstrahlen der ersten Lichtquelle vor Erreichen der ersten Oberfläche, also der unterseitig angeordneten Oberfläche des Bauelementes, umlenkbar sind. Somit ist die Anordnung der ersten Lichtquelle außerhalb einer gemeinsamen optischen Achse, auf welcher die Kameraeinrichtung, das Bauteil und die Strahlteilerplatte liegen, möglich.

Die in der optischen Achse angeordnete Strahlteilerplatte ist vorteilhaft in einer Oberfläche derart ausgebildet, dass sie die zunächst von der ersten Lichtquelle ausgesendeten Lichtstrahlen reflektiert, um diese auf die unterseitige erste Oberfläche des Bauteiles zu lenken, jedoch nicht die an der unterseitigen ersten Oberfläche des Bauteils reflektierten und somit zurückkommenden ersten Lichtstrahlen reflektiert, sondern diese viel mehr lichtdurchlässig transferiert, um sie anschließend auf die unterhalb der Strahlteilerplatte angeordnete Kameraeinrichtung einfallen zu lassen.

Die ersten Lichtstrahlen verlaufen in dem Bereich zwischen der Strahlteilerplatte und dem Bauteil sowohl auf ihrem Hinweg zu dem Bauteil als auch auf ihrem Rückweg von dem Bauteil zu der Kameraeinrichtung parallel zu der optischen Achse oder auf dieser.

Vorzugsweise sind die zweiten Lichtstrahlen der mindestens einen zweiten Lichtquelle auf die mindestens eine zweite Oberfläche mit einem Einfallswinkel zur Oberflächenebene gerichtet und mit einem Ausfallswinkel zu der Oberflächenebene der zweiten Oberfläche von dieser reflektiert. Die von der zweiten Oberfläche bzw. den zweiten Oberflächen reflektierten zweiten Lichtstrahlen werden auf ein Reflektionselement gelenkt, welches an dem Festhalteelement, an welchem das Bauteil befestigt ist, vorzugsweise oberhalb des Bauteils angebracht ist, von diesem erneut reflektiert, um diese anschließend auf die Kameraeinrichtung zu lenken. Hierbei werden die zum zweiten Mal reflektierten zweiten Lichtstrahlen ebenso wie die ersten auf ihrem Rückweg befindlichen Lichtstrahlen durch die Strahlteilerplatte hindurch transferiert und auf die unterhalb oder seitlich der Strahlteilerplatte angeordnete Kameraeinrichtung gelenkt. Die Kameraeinrichtung kann auch jede andere Position im Verhältnis zu der Strahlteilungsplatte aufweisen.

Die Kameraeinrichtung weist mindestens einen Sensor, der vorzugsweise flächenhaft ausgebildet ist, zum Detektieren der reflektierten Lichtstrahlen und zur Erzeugung mindestens eines Bildes der Oberflächen auf, wobei der Sensor die detektierten Bilddaten elektronisch an eine Anzeigeeinrichtung gegebenenfalls unter zuvor erfolgter elektronischer Bilddatenverarbeitung zur Verbesserung der Schärfe der abgebildeten Oberflächen, weitersenden kann.

Das Reflektionselement weist mindestens eine, vorzugsweise zwei oder vier Reflektionsflächen auf, die gegenüber der optischen Achse um einen Winkel geneigt sind, um die einfallenden Lichtstrahlen, welche zuvor an den umlaufenden seitlichen zweiten Oberflächen des Bauteils reflektiert worden sind, im reflektierten Zustand auf die Fläche des Sensors der Kameraeinrichtung unter Berücksichtigung einer entsprechenden Beabstandung zu den anderen abgebildeten Oberflächen zu richten.

Weitere vorteilhafte Ausführungsformen ergeben sich aus den Unteransprüchen.

Vorteile und Zweckmäßigkeit sind in der darauf folgenden Beschreibung zu entnehmen. Hierbei zeigen:
- Fig.1: In einer schematischen Darstellung eine Pick- und Place-Vorrichtung mit einer opti- schen Erfassungsvorrichtung gemäß dem Stand der Technik;
- Fig.2: eine optische Erfassungsvorrichtung gemäß einer Ausführungsform der Erfindung innerhalb einer Pick- und Place-Vorrichtung in schematischer Darstellung ohne ein- gezeichnete Lichtstrahlengänge;
- Fig.3: in einer schematischen Darstellung die in Fig.2 wiedergegebene optische Erfas- sungsvorrichtung mit eingezeichneten Strahlengang von ersten Lichtstrahlen einer ersten Lichtquelle;
- Fig.4: die in Fig.2 gezeigte optische Erfassungsvorrichtung mit eingezeichneten Strahlen- gang von zweiten Lichtstrahlen einer zweiten Lichtquelle, und
- Fig.5: eine Wiedergabe eines Bildes von Oberflächen eines elektronischen Bauteiles, aufgenommen durch die erfindungsgemäße optische Erfassungsvorrichtung.

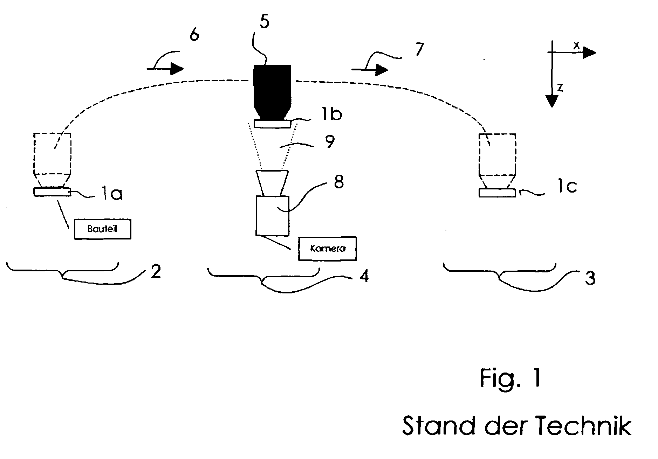

In Fig.1 wird in einer schematischen Darstellung eine Pick- und Place-Vorrichtung mit einer optischen Erfassungseinrichtung gemäß dem Stand der Technik wiedergegeben. Dieser Darstellung ist zu entnehmen, dass ein elektronisches Bauelement 1a, wie es beispielsweise ein Chip sein kann, der quaderförmig ausgebildet ist, von einer Arbeitsstation 2, in der es aufgenommen wird, zu einer Arbeitsstation 3, in der es abgelegt wird, transportiert wird. Das in der Arbeitsstation 3 abzulegende elektronische Bauteil 1c wird zwischen der ersten und der zweiten Arbeitsstation 2, 3 mittels eines Festhalteelementes bzw. Greifers 5 transportiert und durchläuft einen Erfassungs- bzw. Inspektionsbereich 4. Der Transportweg wird durch die Pfeile 6, 7 dargestellt.

In dem Erfassungsbereich 4 ist eine Kameraeinrichtung 8 angeordnet, die in herkömmlicher Weise eine Aufnahme einer unterseitig angeordneten Oberfläche des elektronischen Bauteils 1 b zur Erzeugung eines Bildes durchführt, wie es durch das Bezugszeichen 9 wiedergegeben wird.

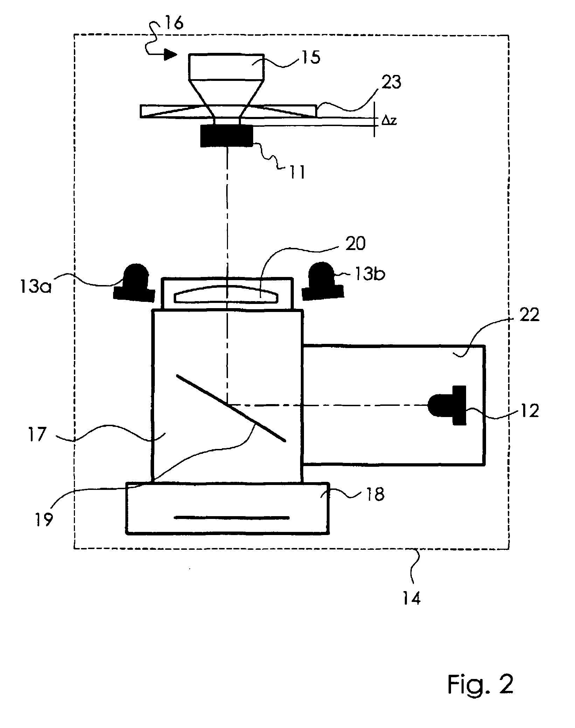

In Fig.2 ist eine optische Erfassungsvorrichtung für eine Pick- und Place-Vorrichtung gemäß einer Ausführungsform der Erfindung wiedergegeben. In der optischen Erfassungsvorrichtung 14 ist ein elektronisches Bauteil 11, eine erste Lichtquelle 12 sowie zweite Lichtquellen 13a und 13b angeordnet.

Die erste Lichtquelle 12 sendet Lichtstrahlen im kurzwelligen Bereich aus, wohingegen die zweite Lichtquellen 13a und 13b Lichtstrahlen im langwelligen Bereich aussenden.

Ein Festhalteelement 15 hält das elektronische Bauteil oberseitig beispielsweise mittels Vakuumbeaufschlagung fest.

Die Transportrichtung des elektronischen Bauteiles während der durchzuführenden Bildaufnahmen wird durch den Pfeil 16 dargestellt, wobei ein Stillstand des elektronischen Bauteiles 11 und somit des Festhalteelementes 15 während einer Bildaufnahme ebenso denkbar ist. In dem Fall eines Stillstandes wird das elektronische Bauteil oberhalb einer Kameraeinrichtung angehalten und es werden mehrere Bildaufnahmen durchgeführt, ohne dass hierfür, ebenso wie bei einem Transport ohne Zwischenstopp - eine Bewegung des Festhalteelementes 15 mit dem elektronischen Bauteil in Z-Richtung, also in Auf- und Abwärtsrichtung, notwendig ist.

Innerhalb eines Objektives 17, das oberhalb in der eigentlichen Kameraeinrichtung 18 angeordnet ist, ist eine Strahlteilerplatte 19 angeordnet, die in Abhängigkeit von der Einfallsrichtung der Lichtstrahlen sowohl reflektierend als auch lichtdurchlässig funktionieren kann.

Eine Linse 20 dient zum Fokussieren der Lichtstrahlen.

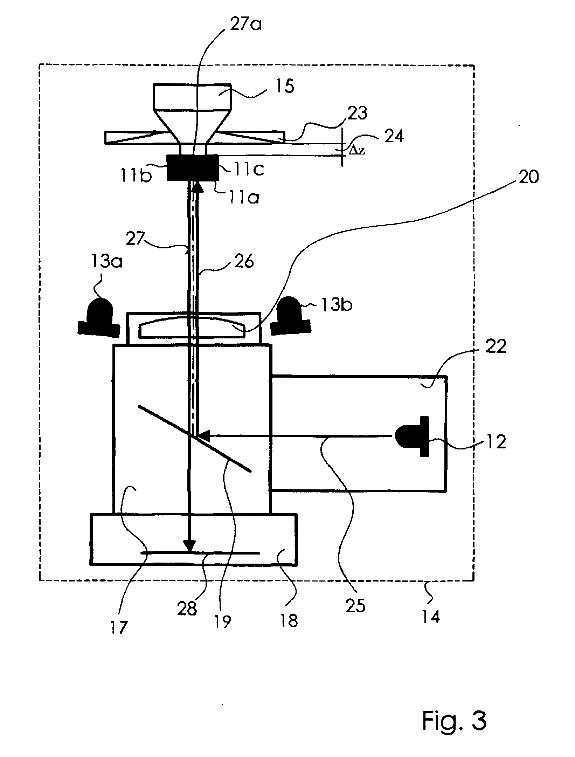

In Fig.3 wird die optische Fassungsvorrichtung gemäß der Ausführungsform der Erfindung mit einem Strahlengang von Lichtstrahlen der ersten Lichtquelle 12 dargestellt.

Oberhalb des elektronischen Bauteiles 11 mit der ersten Oberfläche 11 a und den zweiten Oberflächen 11 b, 11c ist ein Reflektionselement 23 angeordnet, welches gegenüber dem elektronischen Bauteil 11 mit einem Abstand 24 beabstandet ist.

Die erste Lichtquelle 12 sendet Lichtstrahlen 25 aus. Die ersten Lichtstrahlen 25 treffen auf die Strahlteilerplatte 19, die bei dieser Einfallsrichtung eine reflektierende Wirkung hat und die Lichtstrahlen derart reflektiert, dass sie gemäß dem Bezugszeichen 26 auf das elektronische Bauteil umgelenkt werden. Die reflektierten Lichtstrahlen 26 treffen anschließend auf die unterseitige Oberfläche 11a des elektronischen Bauteiles 11 und werden dort, da sie orthogonal zu der Oberflächenebene der Oberfläche 11a eintreffen, um 180° reflektiert, wie es durch das Bezugszeichen 27 wiedergegeben wird.

Die an der Oberfläche 11a reflektierten ersten Lichtstrahlen 27 fallen anschließend aus einer weiteren Einfallsrichtung auf die Strahlteilerplatte 19 ein, die auch ein Spiegel sein kann, der für die Einfallsrichtung lichtdurchlässig durch eine entsprechende Ausbildung seiner Oberfläche wirkt.

Die reflektierten ersten Lichtstrahlen 27 im kurzweiligen Wellenlängenbereich treffen dann auf einen Sensor 28 der vorzugsweise flächenhaft ausgebildet ist, und der eine Detektion der einfallenden Lichtstrahlen und somit eine Wiedergabe der Oberfläche 11a des elektronischen Bauteiles ermöglicht.

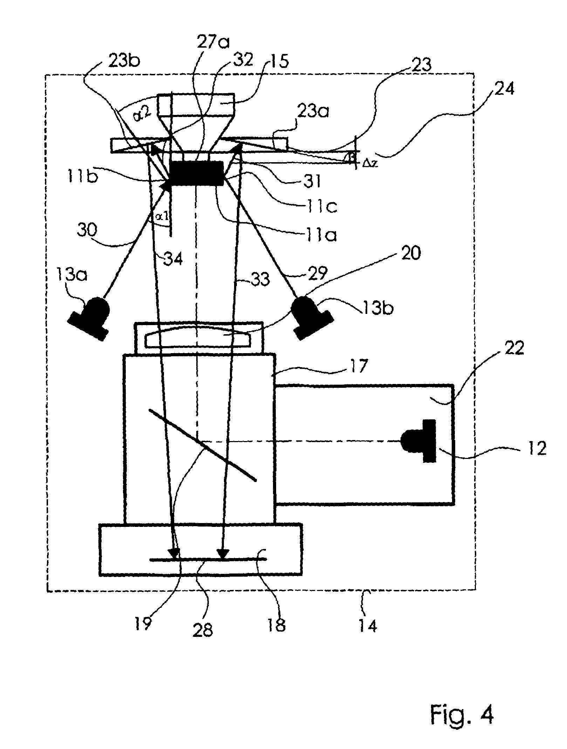

In Fig.4 wird in einer weiteren, schematischen Darstellung die optische Erfassungsvorrichtung gemäß Fig.2 und Fig.3 gezeigt, wobei in dieser Darstellung der Strahlengang zweiter Lichtstrahlen, die von den zweiten Lichtquellen 13a und 13b ausgehen, dargestellt ist.

Die zweiten Lichtstrahlen 29, 30 werden von den zweiten Lichtquellen 13a und 13b, die entsprechend gegenüber den seitlichen Oberflächen 11 b und 11 c ausgerichtet sind, ausgesendet und treffen mit einem Einfallswinkel α₁ auf die seitlichen Oberflächen 11 b und 11 c auf. Zusätzlich können die vorder- und rückseitigen Seitenflächen mit weiteren oder den gleichen zweiten Lichtquellen beleuchtet werden. Dies ist allerdings in dieser Darstellung nicht wiedergegeben.

Die an der Oberfläche mit einem Einfallswinkel α₁ einfallenden Lichtstrahlen 29, 30 werden an diesen Oberflächen 11 b und 11c reflektiert und verlassen die Oberfläche im reflektierten Zustand mit einem Ausfallswinkel α₂. Die an der Oberfläche reflektierte zweiten Lichtstrahlen 31, 32 treffen nun auf eine Reflektionsfläche 23a, 23b des Reflektionselementes 23, welches an dem Festhalteelement 15 befestigt ist. Anschließend findet eine weitere Reflektion dieser zweiten Lichtstrahlen 31, 32 an der Reflektionsfläche 23a, 23b derart statt, dass die daran reflektierten Lichtstrahlen 33, 34 auf den Sensor 28 gelenkt werden. Zuvor durchlaufen diese reflektierten zweiten Lichtstrahlen 33, 34 ebenso die Strahlteilerplatte, die für diese Einfallsrichtung lichtdurchlässig ausgebildet ist.

Die Reflektionsflächen 23a und 23b sind in Abstimmung auf die erwünschten gemeinsamen Fokusebenen der ersten und zweiten Lichtstrahlen in den Bereich des flächenhaften Sensors 28 mit einem Winkel β gegenüber der optischen Achse 27a, auf welcher sich das Festhalteelement 15, das elektronische Bauelement 11, die Linse 20, der Spiegel 19 und der Sensor 28 befinden, ausgerichtet. Ebenso wird in Abhängigkeit von dem gewünschten gemeinsamen Fokusebenen ein Abstand 24, der zwischen dem Reflektionselement 23 und dem elektronischen Bauteil 11 besteht, eingestellt.

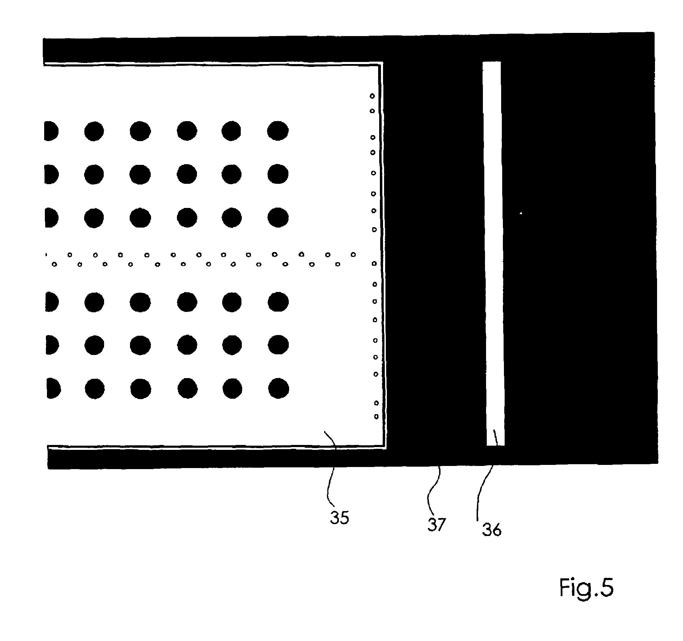

In Fig.5 ist beispielhaft ein Bild, wie es mittels des Sensors 28 durch die einfallenden reflektierten ersten und zweiten Lichtstrahlen erhalten werden kann, dargestellt. Dieses Bild 37 enthält die erste Oberfläche 11a, dargestellt als das Bezugszeichen 35, und eine der zweiten Oberflächen 11b, 11c, wie es durch das Bezugszeichen 36 dargestellt wird. Dieser Darstellung ist deutlich zu entnehmen, dass die Bildaufnahmen die erforderliche Schärfe aufweisen, um beispielsweise Bumps oder Anschlussflächen auf den Oberflächen 11 a, 11 b und 11 c des elektronischen Bauteils, welches ein Chip bzw. ein Die sein kann, zu erkennen.

### Bezugszeichenliste

- 1a, 1b, 1c: Bauteil
- 2: Erste Arbeitsstation
- 3: Zweite Arbeitsstation
- 4: Erfassungsstation
- 5: Festhalteelement
- 6,7: Transportrichtungen
- 8: Kameraeinrichtung
- 9: Aufnahmebereich
- 11: Elektronisches Bauteil
- 11 a: erste Oberfläche
- 11 b,c: zweite Oberflächen
- 12: Erste Lichtquelle
- 13a,13b: Zweite Lichtquellen
- 14: Erfassungsvorrichtung
- 15: Festhalteelement
- 16: Transportrichtung
- 17: Objektiveinrichtung
- 18: Kameraeinrichtung
- 19: Strahlteilerplatte
- 20: Linse
- 22: Weiterer Objektivteil
- 23: Reflektionselement
- 23a,23b: Reflektionsflächen
- 24: Abstand
- 25: Erster Lichtstrahl
- 26: Reflektierter erster Lichtstrahl
- 27: Reflektierter erster Lichtstrahl
- 27a: Optische Achse
- 28: Sensor
- 29,30: Zweite Lichtstrahlen
- 31,32: Reflektierte Lichtstrahlen
- 33,34: Reflektierte Lichtstrahlen
- 35: Bildaufnahme der ersten Oberfläche
- 36: Bildaufnahme der zweiten Oberfläche
- 37: Bild

## Patentansprüche

1. Optische Erfassungsvorrichtung für die Erfassung von mindestens einer Oberfläche (11a) mindestens eines Bauteils (11), wobei das Bauteil (11) mittels eines Festhalteelementes (15) von einer ersten zu einer zweiten Arbeitsstation (2,3) transportierbar ist und eine Kameraeinrichtung (18) auf eine erste Oberfläche (11a) des Bauteiles (11) gerichtet ist,
**gekennzeichnet durch**
mindestens eine Lichtquelle (12), die erste Lichtstrahlen (25,26) im kurzwelligen Bereich zur ersten Oberfläche (11a) sendet,
mindestens eine zweite Lichtquelle (13a,13b), die zweiten Lichtstrahlen (29,30) im langwelligen Bereich zu mindestens einer gegenüber der ersten Oberfläche (11a) verschieden ausgerichteten zweiten Oberfläche (11 b, 11c) des Bauteils (11) sendet, und
die Kameraeinrichtung, welche die an den Oberflächen (11 a-c) reflektierten, ersten und zweiten Lichtstrahlen (27, 33, 34) zur Erzeugung eines Bildes (37) der Oberflächen empfängt.

2. Optische Erfassungsvorrichtung nach Anspruch 1,
**gekennzeichnet durch**
mindestens eine zumindest teilweise reflektierende Strahlteilerplatte(19), an der die ersten Lichtstrahlen (25, 26) der ersten Lichtquelle (12) vor Erreichen der ersten Oberfläche (11a) umlenkbar sind.

3. Optische Erfassungsvorrichtung nach Anspruch 2,
**dadurch gekennzeichnet, dass**
das Bauteil (11), die Strahlteilerplatte(19) und die Kameraeinrichtung (18) auf einer gemeinsamen optischen Achse (27a), auf oder parallel zu welcher die an den Oberflächen (11a-c) des Bauteiles (11) reflektierten ersten Lichtstrahlen (27) verlaufen, angeordnet sind.

4. Optische Erfassungseinrichtung nach einen der vorangegangenen Ansprüche,
**dadurch gekennzeichnet, dass**
die zweiten Lichtstrahlen (29, 30, 31, 32) der mindestens einen zweiten Lichtquelle (13a, 13b) auf die mindestens eine zweite Oberfläche (11b, 11c) mit einem Einfallswinkel (α₁) zur Oberflächenebene gerichtet sind und mit einem Ausfallwinkel (α₂) zu der Oberflächenebene der zweiten Oberfläche (11 b, 11c) von dieser reflektiert werden.

5. Optische Erfassungsvorrichtung nach Anspruch 3,
**gekennzeichnet durch**
ein Festhalteelement (15) angebrachtes Reflektionselement (23) zum Reflektieren der an der zweiten Oberfläche (11b, 11c) reflektierten zweiten Lichtstrahlen (31, 32), um diese auf die Kameraeinrichtung (18) zu lenken.

6. Optische Erfassungseinrichtung nach Anspruch 4,
**dadurch gekennzeichnet, dass**
die Strahlteilerplatte (19) derart ausgebildet ist, dass sie für die aus einer ersten Richtung einfallenden ersten Lichtstrahlen (25) reflektierend und für die aus einer zweiten Richtung einfallenden, an der ersten Oberfläche (11a) reflektierten ersten Lichtstrahlen (27) sowie für die an dem Reflektionselement (23) reflektierten zweiten Lichtstrahlen (33, 34) durchlässig ist.

7. Optische Erfassungsvorrichtung nach einen der vorangegangen Ansprüche,
**dadurch gekennzeichnet, dass**
die Kameraeinrichtung mindestens einen Sensor (28) zum Detektieren der reflektierten Lichtstrahlen und zur Erzeugung mindestens eines Bildes (35-37) der Oberflächen (11a-c) aufweist.

8. Optische Erfassungsvorrichtung nach einem der Ansprüche 2 - 7,
**dadurch gekennzeichnet, dass**
zwischen der Strahlteilerplatte (19) und dem Bauteil (11) im Strahlengang der reflektierten Lichtstrahlen (27, 33, 34) mindestens ein Linsenelement (20) angeordnet ist.

9. Optische Erfassungsvorrichtung nach einem der Ansprüche 4- 7,
**dadurch gekenzeichnet**, dass
das Reflektionselement (23) mindestens eine Reflektionsfläche (23a, 23b) aufweist, die gegenüber der optischen Achse (27a) um einen Winkel (β) geneigt ist.

10. Verfahren für die optische Erfassung von mindestens einer Oberfläche (11 a) mindestens eines Bauteils (11), wobei das Bauteil (11) mittels eines Festhalteelementes (15) von einer ersten zu einer zweiten Arbeitsstation (2,3) transportiert wird und eine Kameraeinrichtung (18) auf eine erste Oberfläche (11a) des Bauteiles (11) gerichtet wird,
**dadurch gekennzeichnet, dass**
mindestens eine Lichtquelle (12) erste Lichtstrahlen (25,26) im kurzwelligen Bereich zur ersten Oberfläche (11a) sendet, und mindestens eine zweite Lichtquelle (13a,13b) zweite Lichtstrahlen (29,30) im langwelligen Bereich zu mindestens einer gegenüber der ersten Oberfläche (11a) verschieden ausgerichteten zweiten Oberfläche (11b, 11c) des Bauteils (11) sendet, und die Kameraeinrichtung die an den Oberflächen (11a-c) reflektierten, ersten und zweiten Lichtstrahlen (27, 33, 34) zur Erzeugung eines Bildes (37) der Oberflächen empfängt.

## Claims

1. Optical detection device for the detection of at least one surface (11a) of at least one component (11), the component (11) being capable of being transported from a first to a second workstation (2, 3) by means of a retaining element (15), and a camera instrument (18) being directed onto a first surface (11a) of the component (11),
**characterised by**
at least one light-source (12) which transmits first light-beams (25, 26) in the short-wave range to the first surface (11a),
at least one second light-source (13a, 13b) which transmits second light-beams (29, 30) in the long-wave range to at least one second surface (11b, 11c) of the component (11) which is oriented differently in relation to the first surface (11a), and
the camera instrument which receives the first and second light-beams (27, 33, 34) reflected on the surfaces (11a-c) for the purpose of generating an image (37) of the surfaces.

2. Optical detection device according to Claim 1,
**characterised by**
at least one at least partly reflecting beam-splitter plate (19), on which the first light-beams (25, 26) of the first light-source (12) are capable of being deflected before reaching the first surface (11a).

3. Optical detection device according to Claim 2,
**characterised in that**
the component (11), the beam-splitter plate (19) and the camera instrument (18) are arranged on a common optical axis (27a), on or parallel to which run the first light-beams (27) reflected on the surfaces (11a-c) of the component (11).

4. Optical detection device according to one of the preceding claims,
**characterised in that**
the second light-beams (29, 30, 31, 32) of the at least one second light-source (13a, 13b) are directed onto the at least one second surface (11b, 11c) with an incidence angle (α₁) relative to the surface plane and are reflected from the second surface with a reflection angle (α₂) relative to the surface plane of the second surface (11b, 11c).

5. Optical detection device according to Claim 3,
**characterised by**
a reflecting element (23), fitted to the retaining element (15), for reflecting the second light-beams (31, 32) reflected on the second surface (11b, 11c), in order to guide said light-beams onto the camera instrument (18).

6. Optical detection device according to Claim 4,
**characterised in that**
the beam-splitter plate (19) is designed in such a manner that it is reflecting for the first light-beams (25) incident from a first direction and transmitting for the first light-beams (27) incident from a second direction and reflected on the first surface (11a) and also for the second light-beams (33, 34) reflected on the reflecting element (23).

7. Optical detection device according to one of the preceding claims,
**characterised in that**
the camera instrument exhibits at least one sensor (28) for detecting the reflected light-beams and for generating at least one image (35-37) of the surfaces (11a-c).

8. Optical detection device according to one of Claims 2-7,
**characterised in that**
at least one lens element (20) is arranged between the beam-splitter plate (19) and the component (11) in the beam path of the reflected light-beams (27, 33, 34).

9. Optical detection device according to one of Claims 4-7,
**characterised in that**
the reflecting element (23) exhibits at least one reflecting face (23a, 23b) which is inclined by an angle (β) in relation to the optical axis (27a).

10. Method for the optical detection of at least one surface (11a) of at least one component (11), the component (11) being transported from a first to a second workstation (2, 3) by means of a retaining element (15), and a camera instrument (18) being directed onto a first surface (11a) of the component (11),
**characterised in that**
at least one light-source (12) transmits first light-beams (25, 26) in the short-wave range to the first surface (11a), and at least one second light-source (13a, 13b) transmits second light-beams (29, 30) in the long-wave range to at least one second surface (11b, 11c) of the component (11) which is oriented differently in relation to the first surface (11a), and the camera instrument receives the first and second light-beams (27, 33, 34) reflected on the surfaces (11a-c) for the purpose of generating an image (37) of the surfaces.

## Revendications

1. Système de détection optique permettant de détecter au moins une surface (11a) d'au moins un composant (11), ledit composant (11) pouvant être transporté d'un premier à un deuxième poste de travail (2, 3) au moyen d'un élément de retenue (15) et un système de caméra (18) étant dirigé vers une première surface (11a) du composant (11),
**caractérisé par**
au moins une source lumineuse (12) qui envoie des premiers rayons lumineux (25, 26) dans une plage de courtes longueurs d'onde vers la première surface (11a),
au moins une deuxième source lumineuse (13a, 13b) qui envoie des deuxièmes rayons lumineux (29, 30) dans une plage de grandes longueurs d'onde vers au moins une deuxième surface (11b, 11c) du composant (11) orientée différemment par rapport à la première surface (11a)
et
le système de caméra (18) qui reçoit les premiers et les deuxièmes rayons lumineux (27, 33, 34) réfléchis sur les surfaces (11a à 11c) pour générer une image (37) desdites surfaces.

2. Système de détection optique selon la revendication 1,
**caractérisé par**
au moins une plaque de division de faisceau (19) au moins partiellement réfléchissante sur laquelle les premiers rayons lumineux (25, 26) de la première source lumineuse (12) peuvent être déviés avant d'atteindre la première surface (11a).

3. Système de détection optique selon la revendication 2,
**caractérisé en ce que**
le composant (11), la plaque de division de faisceau (19) et le système de caméra (18) sont disposés sur un axe optique commun (27a), par lequel ou parallèlement auquel passent les premiers rayons lumineux (27) réfléchis sur les surfaces (11a à 11c) du composant (11).

4. Système de détection optique selon l'une des revendications précédentes,
**caractérisé en ce que**
les deuxièmes rayons lumineux (29, 30, 31, 32) de ladite deuxième source lumineuse (13a, 13b) sont dirigés vers au moins ladite deuxième surface (11b, 11c) selon un angle d'incidence (α₁) par rapport au plan de la surface et sont réfléchis sur celle-ci selon un angle de réflexion (α₂) par rapport au plan de la deuxième surface (11b, 11c).

5. Système de détection optique selon la revendication 3,
**caractérisé par**
un élément de réflexion (23) fixé au moyen d'un élément de retenue (15) permettant de réfléchir les deuxièmes rayons lumineux (31, 32) réfléchis sur la deuxième surface (11b, 11c) pour diriger ceux-ci vers le système de caméra (18).

6. Système de détection optique selon la revendication 4,
**caractérisé en ce que**
la plaque de division de faisceau (19) est formée de telle sorte qu'elle est réfléchissante pour les premiers rayons lumineux (25) incidents provenant d'une première direction et laisse passer les premiers rayons lumineux (27) incidents provenant d'une deuxième direction et réfléchis sur la première surface (11a) ainsi que les deuxièmes rayons lumineux (33, 34) réfléchis sur l'élément de réflexion (23).

7. Système de détection optique selon l'une des revendications précédentes,
**caractérisé en ce que**
le système de caméra présente au moins un capteur (28) permettant de détecter les rayons lumineux réfléchis et de générer au moins une image (35 à 37) des surfaces (11a à 11c).

8. Système de détection optique selon l'une des revendications 2 à 7,
**caractérisé en ce que**
au moins un élément de lentille (20) est disposé entre la plaque de division de faisceau (19) et le composant (11) dans le chemin du faisceau des rayons lumineux réfléchis (27, 33, 34).

9. Système de détection optique selon l'une des revendications 4 à 7,
**caractérisé en ce que**
l'élément de réflexion (23) présente au moins une surface réfléchissante (23a, 23b) inclinée selon un angle (β) par rapport à l'axe optique (27a).

10. Procédé pour la détection optique d'au moins une surface (11a) d'au moins un composant (11), ledit composant (11) étant transporté d'un premier à un deuxième poste de travail (2, 3) au moyen d'un élément de retenue (15) et un système de caméra (18) étant dirigé vers une première surface (11a) du composant (11),
**caractérisé en ce que**
au moins une source lumineuse (12) envoie des premiers rayons lumineux (25, 26) dans une plage de courtes longueurs d'onde vers la première surface (11a) et au moins une deuxième source lumineuse (13a, 13b) envoie des deuxièmes rayons lumineux (29, 30) dans une plage de grandes longueurs d'onde vers au moins une deuxième surface (11b, 11c) du composant (11) orientée différemment par rapport à la première surface (11a) et que le système de caméra (18) reçoit les premiers et les deuxièmes rayons lumineux (27, 33, 34) réfléchis sur les surfaces (11a à 11c) pour générer une image (37) des surfaces.
